## Europäisches Patentamt
## European Patent Office
## Office européen des brevets

(11) Publication number: **0 213 014**
**B1**

# (12) EUROPEAN PATENT SPECIFICATION

(45) Date of publication of patent specification: **19.09.90**

(51) Int. Cl.⁵: **H 01 L 23/50**, H 01 L 21/66

(21) Application number: **86401605.0**

(22) Date of filing: **18.07.86**

(54) **Semiconductor chip package configuration and method for facilitating its testing and mounting on a substrate.**

(30) Priority: **23.07.85 US 758607**

(43) Date of publication of application:
**04.03.87 Bulletin 87/10**

(45) Publication of the grant of the patent:
**19.09.90 Bulletin 90/38**

(84) Designated Contracting States:
**DE FR GB IT NL**

(56) References cited:
**DE-A-3 410 196**
**FR-A-2 568 059**
**US-A-4 466 183**

**PATENT ABSTRACTS OF JAPAN, vol. 7, no. 284**
**(E-2171429r, 17th December 1983; & JP - A - 58**
**161 349 (HITACHI SEISAKUSHO K.K.) 24-09-1983**

**PATENT ABSTRACTS OF JAPAN, vol. 6, no. 128**
**(E-118)1006r, 14th July 1982; & JP - A - 57 53968**
**(NIPPON DENKI K.K.) 31-03-1982**

(73) Proprietor: **FAIRCHILD SEMICONDUCTOR CORPORATION**
**10400 Ridgeview Court P.O. Box 1500**
**Cupertino, California 95014 (US)**

(72) Inventor: **Phy, William S.**
**25616 Moody Road**
**Los Altos Hills California 94022 (US)**

(74) Representative: **Sparing Röhl Henseler**
**Patentanwälte European Patent Attorneys**
**Rethelstrasse 123**
**D-4000 Düsseldorf 1 (DE)**

Courier Press, Leamington Spa, England.

## Description

### Background of the Invention

The present invention relates to a semiconductor chip package configuration and method of formation and more particularly to such a chip package configuration and method of formation for facilitating attaching and testing of the chip package and subsequent surface mounting thereof on a substrate such as a printed circuit board or the like. By chip package, it is meant the combination of a semiconductor chip and surrounding enclosure with protruding leads.

Numerous techniques have been disclosed in the prior art for forming semiconductor chip packages and mounting them on substrates such as printed circuit boards to facilitate subsequent operation. Conventionally, the individual semiconductor chip packages have been electrically tested in test devices having sockets or test heads arranged for electrical communication with the respective leads on the chip package. Such testing makes it necessary, of course, to maintain the leads in electrical isolation from each other. Thereafter, the chip packages are mounted either manually or automatically upon a suitable substrate such as a printed circuit board with the individual leads being interconnected with respective conductors on the substrate. The leads and conductors are then joined together using techniques which are well known in the prior art, such as vapor phase soldering, thermode reflow soldering, etc.

As can be seen, alignment of the leads on the chip package is of critical importance both during testing and mounting. As noted above, the leads must be maintained in electrical isolation from each other during testing. Spacing is equally critical during mounting of the chip package on a substrate in order to assure proper alignment and attachment of the respective leads to conductors on the substrate.

In a conventional technique for forming the basic components of a semiconductor chip package such as referred to above, the leads are formed in a lead frame comprising dam bars and/or tie bars which maintain proper spacing between the leads, facilitate application of the packaging to the chip package, etc. The tie bars connect adjacent leads at their outermost perimeter, while dam bars connect adjacent leads at the innermost point of the leads next to the semiconductor chip package package. However, with the tie bars and dam bars being formed from conductive material along with other portions of the lead frame, they must be removed or disconnected from between the leads before testing of the chip package can begin in order to establish electrical isolation for the leads. Particularly in more recently developed techniques of surface mounting, as contemplated by the present invention, each of the leads project from the semiconductor package in cantilevered fashion so that they are susceptible to dislocation which may result in undesirable contact between adjacent leads or improper registration and, hence mounting of the leads on the substrate.

This problem has been found to be even more severe recently, because of the reduced pitch or spacing of the leads necessitated by the existence of much higher density integrated circuit chip packages having high pin or lead count. For example, in typical semiconductor chip packages of the type employed at the present time, the pitch or spacing of the leads has commonly been reduced from about 0.127-0.0635 cms (0.050 to 0.025 inches) in order to permit greater lead density in the chip packages.

With the contemplation of ever greater lead densities for such semiconductor chip packages, there is an increasing need for means to maintain proper alignment and spacing of the leads during both testing and mounting of the chip packages on suitable substrates.

A method for forming a chip package as set forth in the pre-characterizing portion of patent claim 1, and a chip package as defined in the pre-characterizing portion of patent claim 9 are disclosed in US-A-4,466,183.

It is the teaching of the present invention to provide such a semiconductor chip package configuration and method of formation wherein the lead alignment bar means is formed from a material selected to provide sufficient conductivity between the interconnected leads for minimizing electrostatic discharge conditions between the leads, the material also being sufficiently non-conductive to permit functional and dynamic testing of the leads. Preferably, all of the leads on a chip package are electrical in contact with the lead alignment bar means.

In accordance with the preceding description and statement of objects in connection with the present invention, it is to be noted that the invention is particularly applicable to complex or high cost digital semiconductor devices and more particularly to such digital semiconductor devices in the form of microprocessors, microcontrollers and gate arrays having a high count of external leads or pins. Such semiconductor devices have been found to be particularly sensitive to electrostatic discharge conditions.

Additional objects and advantages of the invention are apparent from the following description having reference to the accompanying drawings.

FIGURE 1 is a plan view of a generally conventional semiconductor chip package of the type contemplated by the present invention, the semiconductor chip package of FIGURE 1 being shown in a stage of its construction or assembly where it includes conductive elements which must be removed prior to testing of the chip package. Thus, FIGURE 1 is also generally representative of the prior art with respect to the present invention.

FIGURE 2 is a view of one embodiment of the present invention wherein alignment bars formed from material selected in accordance with the present invention are arranged in interconnection with the adjacent leads prior to removal of the lead frame conductive tie bars.

FIGURE 3 is a side view in elevation of the chip package configuration of FIGURE 2.

FIGURE 4 illustrates another variation of the embodiment of FIGURE 2, also in accordance with the present invention to provide equal electrical potential.

FIGURE 5 is a view of the semiconductor chip package of FIGURE 2 with the tie bars and dam bars removed so that the chip package is adapted for testing and mounting with the alignment bar means of the present invention.

FIGURE 6 is a side view in elevation of the chip package configuration of FIGURE 5.

FIGURE 7 is a view generally similar to FIGURE 6 with the leads being offset relative to a center line of the chip package for facilitating surface mounting of the chip package on a substrate.

FIGURE 8 is a side view in elevation of the semiconductor chip package of FIGURE 7 mounted upon a suitable substrate such as a printed circuit board.

FIGURE 9 is a view similar to FIGURE 8 with the alignment bars of the present invention removed from the leads of the semiconductor chip package after it is mounted upon and electrically attached to the substrate.

Description of the Preferred Embodiments

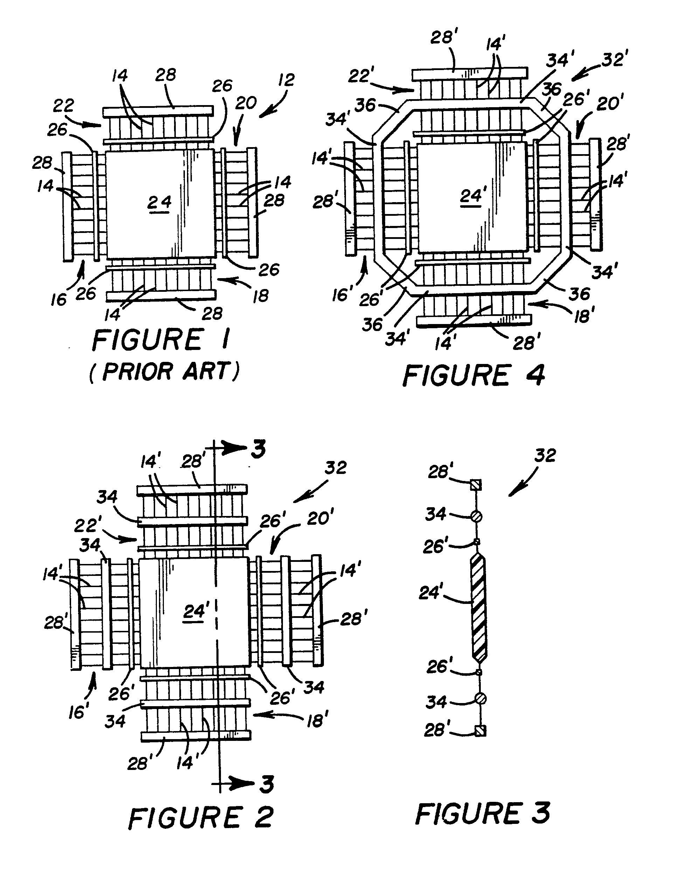

Referring initially to FIGURE 1, a digital semiconductor device configured according to the prior art is generally indicated at 12.

The chip package 12 is of a multi-sided construction having leads 14 arranged in parallel in arrays 16, 18, 20 and 22, each array positioned on a different side of the chip package 12.

The leads 14 are initially formed as part of a lead frame which includes all of the leads 14 and a conventional interconnecting structure (not shown in the figure) underlying the central packaging material 24. The packaging material 24 may for example be either plastic or ceramic depending upon the particular application for the chip package.

The lead frame of the chip package 12 commonly includes integrally formed dam bars 26 and tie bars 28. As illustrated in FIGURE 1, the dam bars 26 form electrically conductive interconnections between the lead 14 closely adjacent to the packaging material 24. At the same time, the tie bars 28 similarly form electrically conductive interconnections between the various arrays of lead 14 at their outboard ends.

The bars 26 and 28 serve different functions at an intermediate stage of manufacture and/or mounting of the chip package 12. The dam bars 26 are employed particularly in connection with chip packages having plastic packaging material 24 which usually is applied to the lead frame by conventional transfer molding. This transfer molding technique involves application of the packaging material 24 to the lead frame with the packaging material being in a semisolid form forced into a mold (not shown) arranged upon the lead frame. During this molding step, the dam bars 26 assist in containing the molded packaging material in place. During this molding process, the tie bars 28 also serve to maintain the proper alignment and spacing of the leads 14.

Upon completion of the molding step as described above, common practice involves interconnection of the individual leads of the chip package 12 with a test head or socket (not shown), the test head also being of conventional construction in accordance with the prior art. As noted above, it is necessary during testing that the leads be electrically isolated from each other in order to permit proper testing of the chip package.

Accordingly, it was also contemplated in the prior art that both the dam bars 26 and tie bars 28 be removed from the chip package prior to testing. This is commonly accomplished by first machining or otherwise removing those portions of the dam bars 26 serving to interconnect the leads 14. During this step, the tie bars 28 maintain proper alignment and spacing of the leads. Thereafter, the tie bars 28 are removed, preferably by cutting or shearing them off from the outboard ends of the leads 14.

It can be seen that the leads 14 become individually cantilevered beams with no means other than their own individual bending or shear strength for maintaining their precise spatial alignment and separation relative to each other. Accordingly, it was found to be relatively difficult in the prior art to achieve proper alignment of the leads with the test head and also to maintain proper alignment and spacing of the leads during mounting of the chip package 12 upon a suitable substrate.

The present invention is particularly contemplated for overcoming or eliminating these problems as is described in detail below with reference to FIGURES 2-9. A wide variety of chip package configurations is encompassed by the present invention. However, the present invention particularly contemplates an integrated circuit chip package adapted for surface mounting with the leads 14 extending from the chip package in generally cantilevered fashion as may be better seen for example with reference to FIGURES 3, 6 and 7. The present invention is applicable to either digital or analog integrated circuits.

Referring first to FIGURE 2, a semiconductor chip package constructed in accordance with the present invention is indicated at 32. The chip package 32 is illustrated in FIGURE 2 in an intermediate state in its manufacture prior to testing and mounting of the chip package upon a substrate, as described hereinbelow. At the same time, the semiconductor chip package 32 includes a number of features corresponding to those described in connection with the prior art chip package of FIGURE 1, those corresponding components being indicated by similar primed numerical labels. For example, the chip package 32 includes similar leads 14' arranged in arrays 16', 18', 20' and 22'. As with the prior art representation of FIGURE 1, the leads 14' are preferably formed as part of an initial lead frame including dam bars 26' and tie bars 28' constructed in the same manner as described above with reference to FIGURE 1.

According to the present invention, chip package 32 differs from chip package 12 of FIGURE 1 in that chip package 32 also includes lead alignment bars 34 interconnecting each of the leads 14'. Preferably, the lead alignment bars 34 are interconnected with the leads 14' intermediate the dam bars 26' and tie bars 28'.

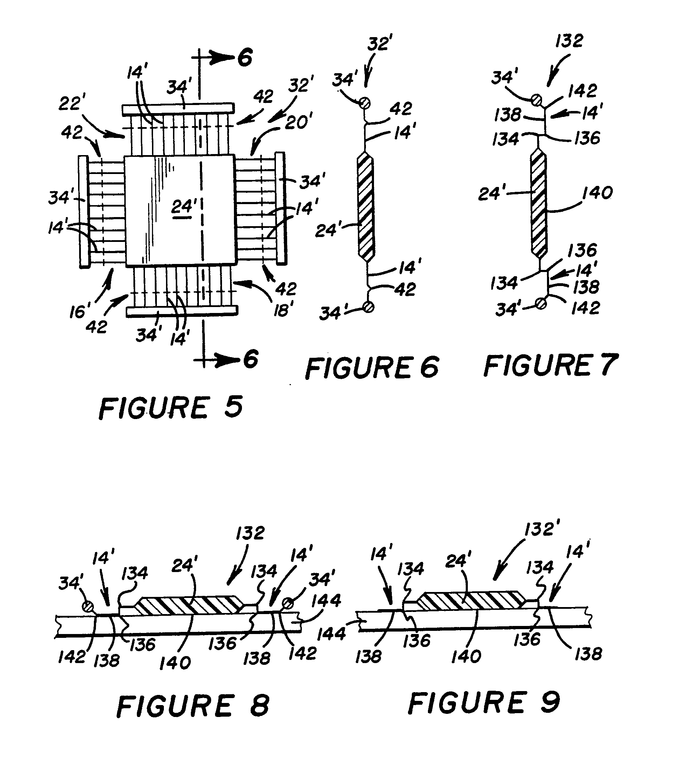

As will be described in greater detail below, the lead alignment bars 34 function to maintain alignment and spacing of the leads both during testing and mounting of the chip package on a suitable substrate and to reduce or minimize electrostatic discharge conditions between the leads 14' during testing and handling. To enable the lead alignment bars 34 to perform this latter function, the bars 34 are preferably formed from semi-conductive material selected to provide sufficient conductivity between the leads 14. At the same time, the material of the lead alignment bars 34 is also selected to be sufficiently non-conductive in order to permit conventional functional and dynamic testing of the chip package's circuits which are internally connected on the chip package to the individual leads. The lead alignment bars 34 preferably serve an additional function of maintaining proper alignment and spacing of the leads 14' to assure their proper alignment with conductors formed on a substrate such as will be described in greater detail below with reference to FIGURES 8 and 9.

The material of the lead alignment bars 34 is selected to exhibit relatively high resistivity preferably in the range of $10^6$ to $10^9$ ohm centimeters. This material may, for example, consist of a semi-conductive plastic or a ceramic material. In the embodiment of FIGURE 2, the lead alignment bars 34 are preferably formed from a high density filled polyurethane material.

With the material of the lead alignment bars 34 being similar to that of the packaging 24', it is thus possible, in cases where the shorting feature is eliminated, for both the packaging 24' and the lead alignment bars 34 to be applied to the chip package 32 during the same molding step commonly employed in the prior art for forming the packaging of the chip package, as described above. In accordance with the present invention, it is only necessary to modify the mold cavities of the prior art in order to permit application of the lead alignment bars 34 at the same time.

Alternatively, the alignment bars 34 could consist of a ceramic material that is attached to the leads 14' in a conventional manner by glass/metal interfaces or by brazing. Another alternative would be to mold a plastic alignment bar 34 on leads 14' of a ceramic packaged chip package 32 after final sealing but prior to trimming of the tie bars 28'.

The construction of the semiconductor chip package 32 as described above in connection with FIGURE 2 is made more apparent by reference to the sectioned view of FIGURE 3.

After construction of the semiconductor chip package 32 in accordance with the preceding description, the dam bars 26' and tie bars 28' may be removed in the same manner as described above for chip package 12 shown in FIGURE 1. For example, the dam bars 26' could again be removed by machining or cutting away interconnecting material between the leads 14'. The tie bars 28' could preferably be removed by shearing or cutting the leads closely adjacent to the lead alignment bars 34.

It is also to be noted in connection with the present invention that, if spacial alignment and separation of the leads 14' could be maintained during preliminary formation of the lead frame, at least up to the point of installing the lead alignment bars 34, the tie bars 28' could be entirely eliminated from the chip package 32 since they serve only a redundant function in combination with the lead alignment bars 34.

Another embodiment of a semiconductor chip package according to the present invention is indicated at 32' in FIGURE 4. In the embodiment 32' of FIGURE 4, the chip package is of substantially similar construction as that described above in connection with FIGURES 2 and 3, except that the lead alignment bars 34' in FIGURE 4 are interconnected with each other as indicated at 36. The interconnections 36 are formed from similar material as the lead alignment bars 34' and may be formed by the same molding operation as the bars 34'.

The chip package 32' is illustrated at a later point of manufacture in FIGURES 5 and 6 wherein the dam bars 26' and tie bars 28' have been removed. Thus, in the embodiment of FIGURES 5 and 6, the lead alignment bars 34' remain to maintain relative alignment and spacing of the leads 14' during electrical testing of the chip package 32' and thereafter, if desired, during mounting of the chip package 32' on a substrate.

As best seen in FIGURE 6, before or after testing chip package 32', in order to facilitate easy removal of the lead alignment bars 34' from chip package 32', the leads 14' are scored, or otherwise similarly subjected to localized stressing or weakening as indicated at 42 inboard of lead alignment bars 34'. This scoring 42 is illustrated in FIGURE 5 by broken lines intersecting each array of leads 14'.

Another embodiment of a semiconductor chip package according to the present invention is illustrated at 132 in FIGURE 7. Chip package 132 is initially formed in substantially the same manner described above in connection with the embodiment 32' of FIGURES 5 and 6. However, where the embodiment of FIGURES 5 and 6 is a "flat" package shaped chip package, the embodiment of FIGURE 7 is a "gell-wing" package. The only difference in the embodiment of FIGURE 7 as compared to that of FIGURES 5 and 6 concerns the configuration of the leads 14' extending laterally in cantilevered fashion from the packaging material 24'. As may be seen in the embodiment of FIGURES 5 and 6, the leads 14' extend directly outwardly from the packaging material. In the embodiment of FIGURE 7, the leads 14' may be formed with two perpendicular angles 134 and 136 closely adjacent the edges of the packaging 24' so that an outboard portion 138 of the leads is arranged generally parallel with a surface 140 of the packaging 24'. The reason for this configuration will be made more apparent below with reference to FIGURES 8 and 9. In any event, the leads 14' in this embodiment are similarly scored at the outboard ends of the segments 138, as indicated at 142, inboard of, and adjacent to the lead alignment bars 34'.

Referring to FIGURE 8, the chip package 132 of FIGURE 7 is illustrated with its surface 140 abutting a substrate 144. The substrate 144, as noted above, may be of a conventional type adapted for surface mounting of semiconductor chip packages thereupon. In accordance with the preceding description, the lead alignment bars 34' serve to maintain proper relative alignment and spacing between the leads 14' while they are mounted upon and interconnected with conventional conductive elements (not shown) on the substrate 144.

After the semiconductor chip package 132 is mounted upon the substrate 144 as described above, the lead alignment bars 34' may be removed, preferably by breaking of the leads 14' at the scored locations 142.

FIGURE 9 is a view similar to FIGURE 8 with the lead alignment bars 34' of the present invention removed from the leads of the semiconductor chip package shown at 132', after it is mounted upon and electrically attached to conductors on substrate 144'.

It should be realized that the present invention is especially suited for high density digital or analog integrated circuit chip packages wherein the minute amounts of current coupled between adjacent leads by the lead alignment bars according to the present invention will not preclude effective testing of the integrated circuit existing on the semiconductor chip package. In most cases, such alignment bars would not be useable on analog integrated circuits or in certain high speed digital circuits where voltage margins are small as compared with currents generated by these partially conductive alignment bars.

Within the preceding description, there have thus been set forth both configurations for a semiconductor chip package and methods for facilitating its testing and mounting upon a suitable substrate. Various modifications and additions within the scope of the invention as defined by the appended claims, are believed obvious within both the chip package configurations and methods of the invention in addition to those referred to above. Accordingly, the scope of the present invention is defined only by the following appended claims.

## Claims

1. A method for forming an integrated circuit semiconductor chip package (32) having a number of closely spaced external leads, including testing the integrated circuit portion internally connected to said leads (14') the chip package being of the type including a lead frame with packaging means (24') applied thereto during the formation of chip package, comprising the steps of: forming lead alignment bar means (34) in interconnecting relation with adjacent leads on the chip package, the lead alignment bar means being adapted to provide electrically isolated physical spacing between said leads during testing of the chip package; electrically testing the chip package integrated circuit while the leads on the chip package are interconnected by the lead alignment bar means; and removing the interconnecting lead alignment bar means from adjacent leads, characterized in that the lead alignment bar means is formed from a material selected to provide sufficient conductivity between the interconnected leads for minimizing electrostatic discharge conditions between the leads, the material being sufficiently non-conductive to permit functional and dynamic testing of the integrated circuit portion internally connected to each individual lead.

2. The method of Claim 1 further comprising the step of mounting the chip package on a substrate before said lead alignment means is removed from adjacent leads.

3. The method of Claim 1 wherein the material forming the lead alignment bar means exhibits resistivity generally in the range of $10^6$ to $10^9$ ohm centimeters.

4. The method of Claim 1 wherein the material forming the lead alignment bar means is selected from the class consisting of semiconductive plastic exhibiting high resistivity and semiconductive ceramic material exhibiting high resistivity.

5. The method of Claim 1 further comprising the step of scoring the interconnected leads intermediate the lead alignment bar means and the packaging means to facilitate removal of the lead alignment bar means.

6. The method of Claim 1 wherein the chip package is of a multi-sided type having sets of leads arranged on each side, lead alignment bar means being interconnected with leads on all sides of the chip package in order to minimize electrostatic discharge conditions from developing between leads on different sides of the chip package.

7. The method of Claim 1 wherein the packaging means and the lead alignment bar means are plastic materials applied to the lead frame by a single molding operation.

8. The method of Claim 7 wherein the lead frame integrally comprises tie bar means at the outer ends of the leads for maintaining physical spacing between the leads, the lead frame also integrally comprising dam bar means interconnecting inner ends of the leads for facilitating formation of the package means, the tie bar means and dam bar means being removed from interconnecting relation with the leads prior to testing of the chip package.

9. An integrated circuit semiconductor chip package (32) of a type having a number of closely spaced leads (14') formed in a lead frame, each said lead internally connected to a portion of said integrated circuit, and packaging means (24') surrounding the integrated circuit such that the closely spaced leads are externally exposed, the chip package being arranged to facilitate testing and subsequent surface mounting of the chip package on a substrate such as a printed circuit board or the like, lead alignment bar means (34) being arranged in interconnecting relation with adjacent leads on the chip package, the lead adjustment bar means being formed from a material providing effective electrical isolation and physical spacing between the leads during testing of the chip package and physical spacing between the leads during mounting of the chip package on the substrate, characterized in that the lead alignment bar means is formed from a material selected to provide sufficient conductivity between the interconnected leads for minimizing electrostatic discharge conditions between the leads, the material being sufficiently non-conductive to permit functional and dynamic testing of the integrated circuits portions connected to said leads.

10. The semiconductor chip package of Claim 9 wherein the lead alignment bar means is adapted for removal from interconnecting engagement with the leads after said chip package is mounted on the substrate.

11. The semiconductor chip package of Claim 9 wherein the material exhibits resistivity generally in the range of $10^6$ to $10^9$ ohm centimeters.

12. The semiconductor chip package of Claim 9 wherein the material is selected from the class consisting of semiconductive plastic exhibiting high resistivity and semiconductive ceramic exhibiting high resistivity.

13. The semiconductor chip package of Claim 9 wherein the interconnected leads are scored intermediate the lead alignment bar means and the packaging means to facilitate removal of the lead alignment bar means after mounting of the semiconductor chip package on the substrate.

14. The semiconductor chip package of Claim 9 being of a multi-sided type having sets of leads arranged on each side, the lead alignment bar means being electrically interconnected with the leads on all sides of the chip package to prevent electrostatic discharge conditions from developing between leads on different sides of the chip package.

15. The semiconductor chip package of Claim 9 wherein the packaging means and the lead alignment bar means are formed from plastic materials applied to the lead frame by a single molding operation.

**Patentansprüche**

1. Ein Verfahren für die Ausbildung einer Chippackung (32) eines integrierten Halbleiter-Schaltkreises mit einer Anzahl in dichtem Abstand vorliegender äußerer Zuleitungen einschließlich des Testens des integrierte Schaltkreisabschnitts, der intern an die Zuleitungen (14') angeschlossen ist, wobei die Chippackung von der Bauart mit einem Leitungsrahmen mit an diesem bei der Bildung der Chippackung angebrachten Packmitteln (24') ist, umfassend die Schritte: Bildung von Leitungsausrichtstabmitteln (34), die benachbarte Zuleitungen auf der Chippackung miteinander verbinden, und die ausgebildet sind zum Vorsehen eines elektrisch isolierten physischen Abstands zwischen den Zuleitungen während des Testens der Chippackung; elektrisches Testen der Chippackung des integrierten Schaltkreises, während die Zuleitungen auf der Chippackung durch die Leitungsausrichtstabmittel verbunden sind; und Entfernen der verbindenden Leitungsausrichtstabmittel von benachbarten Zuleitungen, dadurch gekennzeichnet, daß die Leitungsausrichtstabmittel aus einem Material gebildet werden, das ausgewählt wird, um eine hinreichende Konduktivität zwischen den verbundenen Zuleitungen bereitzustellen für Minimierung elektrostatischer Entladebedingungen zwischen den Zuleitungen, welches Material hinreichend nichtleitend ist, um das funktionsmäßige und dynamische Testen des integrierten Schaltkreisabschnitts zu ermöglichen, der intern an jede einzelne Zuleitung angeschlossen ist.

2. Das Verfahren nach Anspruch 1, ferner umfassend den Schritt der Montage der Chippackung auf einem Substrat, bevor das Leitungsausrichtmittel von benachbarten Zuleitungen entfernt wird.

3. Das Verfahren nach Anspruch 1, bei dem das Material der Leitungsausrichtstabmittel einen Widerstand aufweist, der generell im Bereich von $10^6$ bis $10^9$ Ohm Zentimeter liegt.

4. Das Verfahren nach Anspruch 1, bei dem das die Leitungsausrichtstabmittel bildende Material aus der Klasse ausgewählt wird, bestehend aus halbleitendem Kunststoff mit hohem Widerstand und halbleitendem Keramikmaterial mit hohem Widerstand.

5. Das Verfahren nach Anspruch 1, ferner umfassend den Schritt des Anschneidens der verbundenen Zuleitungen zwischen den Leitungsausrichtstabmitteln und den Packmitteln zum Erleichtern der Entfernung der Leitungsausrichtstabmittel.

6. Das Verfahren nach Anspruch 1, bei dem die Chippackung vom Mehrseitentyp ist mit Sätzen von Zuleitungen, die auf jeder Seite angeordnet sind, wobei Leitungsausfluchtstabmittel mit Zuleitungen auf allen Seiten der Chippackung verbunden sind, um die Entwicklung elektrostatischer Entladebedingungen zwischen Zuleitungen auf unterschiedlichen Seiten der Chippackung zu minimieren.

7. Das Verfahren nach Anspruch 1, bei dem die Packmittel und die Leitungsausrichtstabmittel Kunststoffmaterialien sind, die an dem Leitungsrahmen durch einen einzigen Formarbeitsgang angebracht werden.

8. Das Verfahren nach Anspruch 7, bei dem der Leitungsrahmen integral Bindestabmittel an den äußeren Enden der Zuleitungen umfaßt für das Aufrechterhalten des physischen Abstands zwischen den Zuleitungen und der Leitungsrahmen außerdem integral Dämmstabmittel umfaßt, die innere Enden der Zuleitungen verbinden zum Erleichtern der Bildung der Packmittel, welche Bindestabmittel und Dämmstabmittel von der Verbindung mit den Zuleitungen gelöst werden, bevor die Chippackung getestet wird.

9. Eine Chippackung (32) einer integrierten Halbleiterschaltung einer Bauart mit einer Anzahl in dichtem Abstand vorliegender Zuleitungen (14'), ausgebildet in einem Leitungsrahmen, wobei jede Zuleitung intern an einen Abschnitt der integrierten Schaltung angeschlossen ist, und Packmittel (24'), die die integrierte Schaltung derart umschließen, daß die in dichtem Abstand vorliegenden Zuleitungen extern freiliegen, welche Chippackung ausgebildet ist zum Erleichtern des Testens und nachfolgende Oberflächenmontage der Chippackung auf einem Substrat, wie einer gedruckten Schaltungsplatte oder dergleichen, wobei Leitungsausfluchtstabmittel (34) mit benachbarten Zuleitungen auf der Chippackung verbunden sind und aus einem Material bestehen, das eine wirksame elektrische Isolation und physische Abstände zwischen den Zuleitungen während des Testens der Chippackung sowie physische Abstände zwischen den Zuleitungen während der Montage der Chippackung auf dem Substrat bewirkt, dadurch gekennzeichnet, daß die Leitungsausrichtstabmittel aus einem Material gebildet sind, ausgewählt zum Bereitstellen einer hinreichenden Konduktivität zwischen den verbundenen Zuleitungen für Minimierung elektrostatischer Entladebedingungen zwischen den Zuleitungen, welches Material hinreichend nichtleitend ist, um das funktionelle und dynamische Testen des an die Zuleitungen angeschlossenen integrierten Schaltungsabschnitts zu ermöglichen.

10. Die Halbleiterchippackung nach Anspruch 9, bei der die Leitungsausrichtungsstabmittel ausgebildet sind für ihre Entfernung aus dem Verbindungseingriff mit den Zuleitungen, nachdem die Chippackung auf dem Substrat montiert ist.

11. Die Halbleiterchippackung nach Anspruch 9, bei der das Material einen Widerstand generell in der Größenordnung von $10^6$ bis $10^9$ Ohm Zentimeter aufweist.

12. Die Halbleiterchippackung nach Anspruch 9, bei der das Material aus der Klasse ausgewählt ist, bestehend aus halbleitendem Kunststoff mit hohem Widerstand und halbleitender Keramik mit hohem Widerstand.

13. Die Halbleiterchippackung nach Anspruch 9, bei der die verbundenen Zuleitungen zwischen den Leitungsausrichtstabmitteln und den Packmitteln angeschnitten sind zum Erleichtern des Entfernens der Leitungsausrichtstabmittel nach Montage der Halbleiterchippackung auf dem Substrat.

14. Die Halbleiterchippackung nach Anspruch 9 vom Mehrseitentyp mit Sätzen von Zuleitungen auf jeder Seite angeordnet, wobei die Leitungsausrichtstabmittel elektrisch mit den Zuleitungen auf allen Seiten der Chippackung verbunden sind zum Unterbinden der Entwicklung elektrostatischer Entladebedingungen zwischen Zuleitungen auf unterschiedlichen Seiten der Chippackung.

15. Die Halbleiterchippackung nach Anspruch 9, bei der die Packmittel und die Leitungsausrichtstabmittel aus Kunststoffmaterial gebildet sind, aufgebracht auf den Leitungsrahmen in einem einzigen Formarbeitsgang.

**Revendications**

1. Procédé pour former un boîtier (32) pour puce en semi-conducteur de circuit intégré ayant des broches externes (14') espacées, comprenant le contrôle de la partie de circuit intégré reliée de façon interne auxdites broches (14'), le boîtier pour puce étant du type comprenant un cadre conducteur avec des moyens d'encapsulage (24') appliqués à ce dernier pendant la formation du boîtier pour puce, comprenant les étapes consistant à: former des barres (34) d'alignement des broches en relation d'interconnexion avec les broches adjacentes du boîtier pour puce, les barres d'alignement des broches étant aptes à fournir un espacement physique isolé électriquement entre lesdites broches pendant le contrôle du boîtier pour puce; à contrôler électriquement les circuits intégrés du boîtier pour puce pendant que les broches du boîtier pour puce sont interconnectées par les barres d'alignement des broches; et à retirer des broches adjacentes les barres d'alignement des broches réalisant leur interconnexion, caractérisé en ce que les barres d'alignement des broches sont formées d'un matériau choisi pour fournir une conductivité suffisante entre les broches interconnectées pour minimiser les conditions de décharge électrostatique entre les broches, le matériau étant suffisamment non-conducteur pour permettre un contrôle fonctionnel et dynamique de la partie de circuit intégré relié de façon interne à chaque broche individuelle.

2. Procédé selon la revendication 1, comprenant en outre l'étape consistant à monter le boîtier pour puce sur un substrat avant que lesdits moyens d'alignement des broches soient retirés des broches adjacentes.

3. Procédé selon la revendication 1, selon lequel le matériau formant les barres d'alignement des broches présente une résistivité s'étendant généralement dans une gamme de $10^6$ à $10^9$ ohms centimètres.

4. Procédé selon la revendication 1, selon lequel le matériau formant les barres d'alignement des broches est choisi dans la classe comprenant un plastique semi-conducteur présentant une résistivité élevée et un matériau céramique semiconducteur présentant une résistivité élevée.

5. Procédé selon la revendication 1, comprenant en outre l'étape consistant à entailler les broches interconnectées entre les barres d'alignement des broches et les moyens d'encapsulage pour faciliter le retrait des barres d'alignement des broches.

6. Procédé selon la revendication 1, selon lequel le boîtier pour puce est du type à plusieurs côtés ayant des jeux de broches disposés sur chaque côté, les barres d'alignement des broches étant interconnectées avec les broches sur tous les côtés du boîtier pour puce afin de minimiser la création de conditions de décharge électrostatique entre les conducteurs sur différents côtés du boîtier pour puce.

7. Procédé selon la revendication 1, selon lequel les moyens d'encapsulage et les barres d'alignement des broches sont des matériaux plastiques appliqués sur le cadre conducteur en une seule opération de moulage.

8. Procédé selon la revendication 7, selon lequel le cadre conducteur comprend, venant d'une seule pièce, les barres de liaison aux extrémités extérieures des broches pour maintenir un espacement physique entre les broches, le cadre conducteur comprenant également, venue d'une seule pièce, des barres de barrage interconnectant des extrémités intérieures des broches pour faciliter la formation des moyens d'encapsulage, les barres de liaison et les barres de barrage étant retirées de leur relation d'interconnexion avec les broches avant le contrôle du boîtier pour puce.

9. Boîtier pour puce en semi-conducteur de circuit intégré (32) du type ayant des broches étroitement espacées (14') formées dans un cadre conducteur, chacune desdites broches étant connectée de façon interne à une partie dudit circuit intégré, et des moyens d'encapsulage (24') enveloppant le circuit intégré de sorte que les broches étroitement espacées sont exposées à l'extérieur, le boîtier pour puce étant ménagé de façon à faciliter le contrôle et le montage en surface subséquent du boîtier pour puce sur un substrat tel qu'une plaque de circuit imprimé ou analogue, les barres d'alignement des broches (34) étant disposées selon une relation d'interconnexion avec des broches adjacentes du boîtier pour puce, les barres d'ajustement des broches étant formées d'un matériau fournissant une isolation électrique effective et un espacement physique entre les broches pendant le contrôle du boîtier pour puce et un espacement physique entre les broches pendant le montage du boîtier pour puce sur le substrat, caractérisé en ce que les barres d'alignement des broches sont formées d'un matériau choisi pour fournir une conductivité suffisante entre les broches interconnectées pour minimiser les conditions de décharge électrostatique entre les broches, le matériau étant suffisamment non-conducteur pour permettre un contrôle fonctionnel et dynamique des parties de circuits intégrés reliées auxdites broches.

10. Boîtier pour puce en semi-conducteur selon la revendication 9 dans lequel les barres d'alignement des broches sont aptes à être retirées d'un engagement interconnectant avec les broches, après que ledit boîtier pour puce a été monté sur le substrat.

11. Boîtier pour puce en semi-conducteur selon la revendication 9 dans lequel le matériau présente une résistivité s'étendant généralement dans une gamme de $10^6$ à $10^9$ ohms centimètres.

12. Boîtier pour puce en semi-conducteur selon la revendication 9 dans lequel le matériau est choisi dans la classe comprenant un plastique semi-conducteur présentant une résistivité élevée et une céramique semi-conductrice présentant une résistivité élevée.

13. Boîtier pour puce en semi-conducteur selon la revendication 9 dans lequel les broches interconnectées sont entaillées entre les barres d'alignement des broches et les moyens d'encapsulage pour faciliter le retrait des barres d'alignement des broches après le montage du boîtier pour puce en semi-conducteur sur le substrat.

14. Boîtier pour puce en semi-conducteur selon la revendication 9 étant du type à plusieurs ayant des jeux de broches disposées sur chaque côté, les barres d'alignement des broches étant interconnectées électriquement avec les broches sur tous les côtés du boîtier pour puce pour empêcher le développement de conditions décharge électrostatique entre les broches sur les différents côtés du boîtier pour puce.

15. Boîtier pour puce en semi-conducteur selon la revendication 9 dans lequel les moyens d'encapsulage et les barres d'alignement des broches sont formés de matériaux plastiques appliqués sur le cadre conducteur en une seule opération de moulage.

FIGURE 1
(PRIOR ART)

FIGURE 4

FIGURE 2

FIGURE 3

FIGURE 5

FIGURE 6

FIGURE 7

FIGURE 8

FIGURE 9